# EUROPÄISCHE PATENTANMELDUNG

(11) **EP 0 822 588 A2**
(43) Veröffentlichungstag der Anmeldung: **04.02.1998**
(21) Anmeldenummer: 97113232.9
(22) Anmeldetag: 31.07.1997
(51) Int. Cl.: H01L 21/322, H01L 21/22

(54) **Dotiertes Siliziumsubstrat**

(30) Priorität: 01.08.1996 DE 19631115
(71) Anmelder: SIEMENS AKTIENGESELLSCHAFT, 80333 München (DE)
(72) Erfinder: Behnke, Gudrun, Dr., 86199 Augsburg (DE); Wecker, Dorit, Dr., 82008 Unterhaching (DE); Mayer, Karl, 9500 Villach (AT)

(57) **Zusammenfassung**

Es wird vorgeschlagen, die als Diffusionsbarriere für Dotierstoffe dienende Siliziumoxidschicht 3 zwischen Siliziumsubstrat 1 und Polysiliziumschicht 4 anzuordnen. Dadurch sind keine Zusatzmaßnahmen zur Vermeidung des Autodopingeffekts erforderlich und die getternde Wirkung der Polysiliziumschicht 4 auf der Siliziumsubstratrückseite 2 bleibt erhalten.

## Beschreibung

Die Erfindung betrifft ein dotiertes, insbesondere hochdotiertes, Siliziumsubstrat. Hochdotierte Siliziumsubstrate werden, bevor sie prozessiert werden, insbesondere mit einer Epitaxieschicht, auf ihrer Substratrückseite mit einer Getterschicht aus Polysilizium und darauf mit einer Siliziumoxidschicht zur Vermeidung des sogenannten Autodopingeffektes versehen. Unter dem Autodopingeffekt versteht man, daß Dotierstoffe aus der Substratrückseite ausdiffundieren und in die Substratvorderseite eingebaut werden.

Die Getterschicht aus Polysilizium dient zum Auffangen metallischer Kontaminationen, die ansonsten z.B. zu Gateoxidausfällen in fertig prozessierten Bausteinen führen würden. Während der Hochtemperaturorozeßschritte diffundieren aber auch Dotierstoffe aus dem Siliziumsubstrat in die Polysiliziumschicht. Je nach Löslichkeit reichert sich die Polysiliziumschicht unterschiedlich stark mit Dotierstoffen an, so daß eine Sättigung der Polysiliziumschicht eintritt und diese die auftretenden Metallkontaminationen nur noch ungenügend gettern kann. Demzufolge treten u.a. Gateoxidausfälle auf.

Ferner kann während der Prozessierung des epitaxierten Siliziumsubstrats die Siliziumoxidschicht weggeätzt werden, so daß es auch dadurch zur Ausdiffusion von Dotierstoffen aus der angereicherten Polysiliziumschicht und somit Autodoping sowie Querkontamination zu anderen zu prozessierenden Siliziumsubstraten auftreten.

Diesem Problem begegnete man bisher dadurch, daß man wegen der Ausdiffusion aus der siliziumoxidfreien Substratrückseite getrennte Ofenfahrten bei Hochtemperaturprozessen durchführte, so daß die Gefahr der Querkontamination zu anderen zu prozessierenden Produkten verhindert wurde. Dieses Vorgehen führt zu einer unnötig hohen Auslastung der Fertigungskapazität.

Des weiteren versuchte man dem Problem dadurch zu begegnen, daß man die Siliziumsubstratrückseite mit einer zusätzlichen Siliziumnitridversiegelung versah. Diese Maßnahme führte allerdings einerseits zu Gateoxidausfällen und andererseits zu zusätzlichen Kosten wegen der zusätzlichen Arbeitsschritte.

Aufgabe der vorliegenden Erfindung ist es daher, ein dotiertes Siliziumsubstrat bereitzustellen, dessen Substratrückseite so behandelt ist, daß die obengenannten Komplikationen ausgeschlossen werden können.

Erfindungsgemäß wird diese Aufgabe durch ein dotiertes Siliziumsubstrat gelöst, bei dem auf der Siliziumsubstratrückseite eine Siliziumoxidschicht aufgebracht ist und auf diese Siliziumoxidschicht eine Polysiliziumschicht aufgebracht ist.

Die Vorteile bei diesem dotierten Siliziumsubstrat liegen darin, daß der Dotierstoff nicht mehr durch das Siliziumoxid und damit in die Polysiliziumschicht diffundieren kann, d.h. es findet kein Ausdampfen des Dotierstoffs aus dem Polysilizium statt. Dadurch hat die Polysiliziumschicht noch genügend 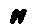 freie Fehlstellen" zum Gettern der auftretenden Metallkontaminationen.

Die eingangs genannten Maßnahmen wahrend des Prozessierens, die gegen das Ausdampfen (Autodopingeffekt, Querkonterminationen) getroffen wurden, können entfallen.

In bevorzugter Ausführung ist die Siliziumoxidschicht ungefähr 50 nm und die darauf aufgebrachte Polysiliziumschicht ungefähr 1,2 µm dick.

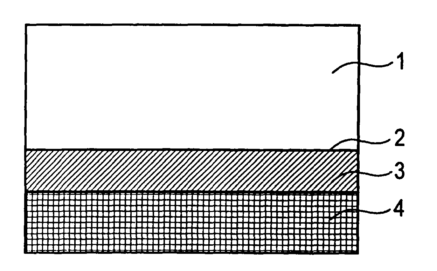

Die Erfindung ist in der Zeichnung beispielsweise veranschaulicht und im nachstehenden im einzelnen anhand der Zeichnung beschrieben.

Wie aus der Figur zu ersehen ist, ist gemäß der Erfindung auf die Siliziumsubstratrückseite 2 eines Siliziumsubstrats 1 direkt eine Siliziumoxidschicht 3 aufgebracht und auf diese Siliziumoxidschicht 3 eine Polysiliziumschicht 4. Die Siliziumoxidschicht 3 dient als Diffusionsbarriere für Dotierstoffe zwischen Siliziumsubstratrückseite 2 und der Polysiliziumschicht 4. Dadurch sind keine weiteren Maßnahmen zur Vermeidung von Autodopingeffekt und von Querkontaminationen zu anderen zu prozessierenden Siliziumsubstraten mehr erforderlich und die getternde Wirkung der Polysiliziumschicht 4 auf der Siliziumsubstratrückseite 2 bleibt erhalten.

Das Siliziumsubstrat 1 ist hier mit dem Dotierstoff Arsen in einer Konzentration > 10¹⁸/cm³ versehen. Die Siliziumoxidschicht 3 weist eine Dicke von ungefähr 50 nm auf und die Polysiliziumschicht 4 weist eine Dicke von ungefähr 1,2 µm auf.

Das hier gezeigte hochdotierte Siliziumsubstrat 1 dient als Grundmaterial für die Herstellung von Leistungshalbleitern.

## Patentansprüche

1. Dotiertes Siliziumsubstrat (1),
**dadurch gekennzeichnet,** daß auf der Siliziumsubstratrückseite (2) eine Siliziumoxidschicht (3) aufgebracht ist und daß auf der Siliziumoxidschicht (3) eine Polysiliziumschicht (4) aufgebracht ist.

2. Siliziumsubstrat nach Anspruch 1,
**dadurch gekennzeichnet,** daß die Siliziumoxidschicht (3) eine Dicke von ungefähr 50 nm und/oder die Polysiliziumschicht (4) eine Dicke von ungefähr 1,2 µm aufweist.

3. Siliziumsubstrat nach Anspruch 1 oder 2,
**dadurch gekennzeichnet,** daß das Siliziumsubstrat (1) mit einer Dotierstoffkonzentration von ≥10¹⁸ Dotieratomen/cm³ versehen ist.

4. Verwendung eines hochdotierten Siliziumsubstrats (1), bei welchem auf der Siliziumsubstratrückseite (2) eine Siliziumoxidschicht (3) und auf dieser Siliziumoxidschicht (3) eine Polysiliziumschicht (4) aufgebracht ist, als Grundmaterial für die Herstellung von Leistungshalbleitern.
